# EUROPEAN PATENT APPLICATION

(11) **EP 2 537 955 A1**
(43) Date of publication of application: **26.12.2012**
(21) Application number: 12169925.0
(22) Date of filing: 30.05.2012
(51) Int. Cl.: C23C 14/50, C23C 14/54

(54) **A method of supporting a workpiece during physical vapour deposition**

(30) Priority: 21.06.2011 GB 201110476
(71) Applicant: SPTS Technologies Limited, Newport Gwent NP18 2TA (GB)
(72) Inventor: Burgess, Stephen, Ebbw Vale, Gwent NP23 5NA (GB)
(74) Representative: Dunlop, Brian Kenneth Charles

(57) **Abstract**

This invention relates to methods of supporting a work piece during a physical vapour deposition and to a related apparatus. An aluminium support (11) having a support surface coated with a heat absorbent coating (15) is provided. The support is cooled to around 100°C and a PVD process is performed such that, with cooling, the work piece temperature is between 350°C and 450°C. The coating is inert and/or ultra-high voltage compatible.

## Description

This invention relates to a method of supporting of workpiece during I physical vapour deposition (PVD) and physical vapour deposition apparatus a support for a workpiece.

### Background

High powered transistors often use thick aluminium layers as contact layers in order to handle the very high current densities inherent in these devices. Thick Al films are needed to minimise contact resistance and hence switching losses, which can reduce device speeds and efficiency. Typically the devices have a vertical architecture with a source contact comprising one or more aluminium layers 1-20µ in thickness deposited onto a semiconductor device embedded on a full thickness wafer.

Aluminium and aluminium films may be deposited onto wafers by magnetron sputtering techniques. Thus a DC power supply is connected between an aluminium target and an annular anode ring. When the system is evacuated and the part to be coated is positioned on support below the target, a low pressure discharge (typically at around several mT) is formed and material is sputtered from the target onto the wafer. Using this technique to deposit thick metal coatings can result in significant increases in the temperature of the wafer being coated as heat from the plasma and instant flux of metal ions or neutral molecules is difficult to remove in a vacuum system. However, there are frequently limits to the temperature that the wafer may attain during production and 450°C is a common ceiling and is a typical maximum temperature for back end of line integration schemes.

In contrast productivity demands high deposition rates, which in turn leads to high DC powers of the target and these high powers result in significant heat load on the wafers.

Most commonly wafer temperature is controlled by gas conduction between the wafer and the wafer support either including the use of an electrostatic clamp or a mechanical clamping system. Whilst both these approaches work they can be relatively costly to implement in practice and their performance tends to degrade as sputtered material begins to coat the fixture.

### Summary of Invention

From one aspect the invention consists in a method of supporting a workpiece during Physical Vapour Deposition (PVD) including
(a) providing an aluminium surface coated with a heat absorbing coating;
(b) cooling the support to around 100°C; and
(c) operating the PVD process to such that with cooling the workpiece temperature is between 350°C and 450°C.

Methods involving the use of a coated workpiece support are known and are, for example, disclosed in US Patent 5183402. In this patent the objective is to maintain the wafer at the platen temperature. However, aluminium has always been regarded as an unsuitable platen material for high temperature operation (>-400C) and to date platens have been typically made with stainless steel. A person skilled in the art would not expect aluminium to require a coating because it is known to have a better thermal conductivity than stainless steel. However, as will be shown below, the inventors have determined that the coating has a substantive effect only in a particular temperature regime as set out above.

The coatings will be inert and/or ultra high voltage compatible. Example coatings are CrOₓ or Al₂O₃.

From another aspect the invention consists in a Physical Vapour Deposition apparatus including a vacuum chamber and a support disposed in the chamber for supporting a workpiece and a cooling circuit for cooling the support when the support includes an aluminium body having a support face and a support face is coated with a heat absorbing coating.

Preferably the coating is as set out above. In a particular embodiment the support is cooled to around 100°C.

The method and apparatus set out above are particularly suitable for use in high deposition of aluminium by sputtering.

Although the invention has been defined above it is to be understood that it includes any inventive combination of the features set out above or in the following description.

The invention may be performed in various ways and specific embodiments will now be described by way of example with reference to the accompanying drawings in which:
Figure 1 is a schematic view of a sputtering apparatus;
Figure 2 illustrates the effect of the coating in a particular temperature range for a target having a 26kw power supplied;
Figure 3 is a corresponding graph for a 40kw set up; and
Figure 4 is a table setting out wafer temperature and deposited film grain size for aluminium and aluminium / CrOx coated platen assemblies with DC power 40kW and platen temperature controlling at 100C.

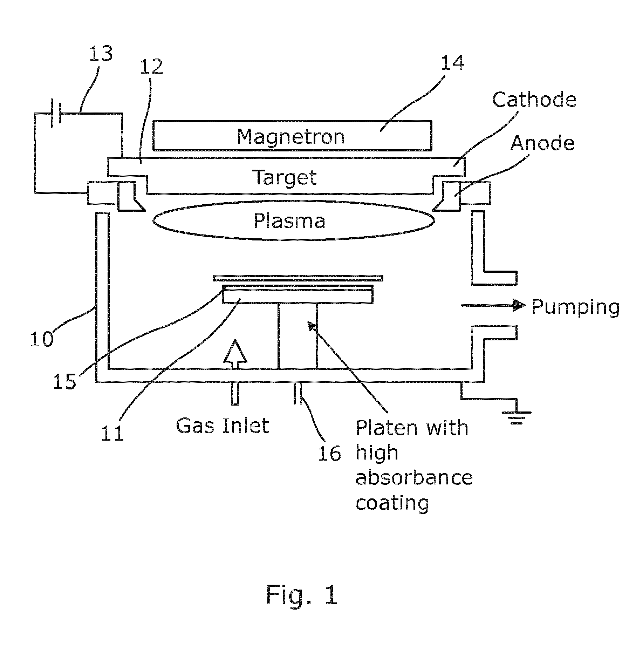

In Figure 1 a vacuum chamber 10 contains a support or platen 11 with an opposed target 12. As known in the art the target has a varying magnetic field generated by magnetron 13 and is powered by DC supply 14. As is also known in the art, a plasma 15 is struck within the chamber and ions are drawn to the target from the plasma to sputter aluminium from the target which descends onto wafer 16 that is carried on the support 11.

In general at above 350°C to 400°C a silicon wafer emits significant quantities of thermal radiation. For the most part, due for example to the aluminium coating on top of silicon dioxide layer on a silicon wafer, any heat transfer from the wafer will be restricted to the back surface of the wafer.

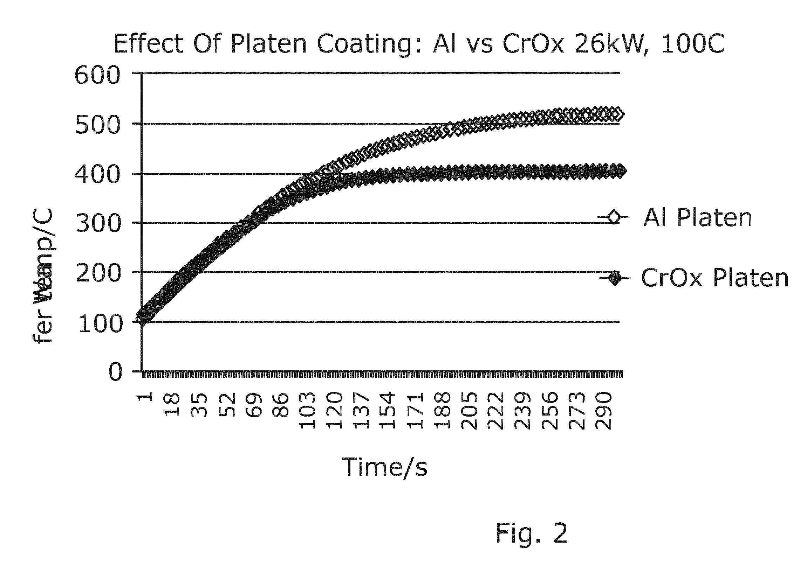

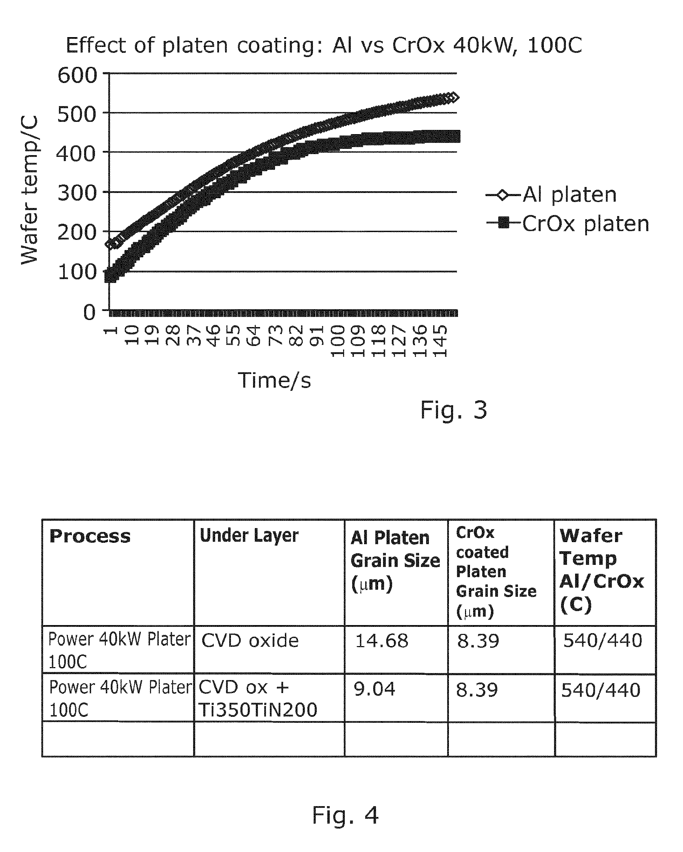

As the Applicants were interested in high deposition rate processes involving significant powers, and hence heating, they decided to try an aluminium platen, because of its greater heat conductivity. However, as can be seen in Figures 2 and 3 when they experimented with an aluminium platen cooled to 100°C for two different power regimes, they found that the wafer temperature continued to rise until it was way above 450°C and so the process was, surprisingly, unacceptable. However, when the platen was coated with an inert ultra high voltage compatible coating, the wafer temperate flattened out at around 350°C and in both cases kept the platen temperature below 450°C. Indeed in the first instance it was held at 400°C.

This arrangement accordingly, surprisingly, provides a very effective way of cooling the wafer in a high temperature process without the need for gas back side cooling, electrostatic clamps or even mechanical clamping systems.

Figure 4 illustrates that the 40kW process on an aluminium platen controlling at 100°C results in a wafer temperature of 540°C either on a SiO₂ or the SiO₂/Ti/TiN liner while the platen assembly with the absorbing coating maintains the wafer temperature at 440°C. The smaller grain sizes observed for the coated platen assembly are indicative of the lower wafer temperature. The process requirement for this device restricted the BEOL thermal budget to <450°C and as such the conventional aluminium platen could not be used.

## Claims

1. A method of supporting a workpiece during Physical Vapour Deposition (PVD) including
(a) providing an aluminium support having a support surface coated with a heat absorbing coating;
(b) cooling the support to around 100°C; and
(c) operating the PVD process such that, with cooling, the workpiece temperature is between 350°C and 450°C.

2. A method as claimed in claim 1 wherein the coating is inert and/or Ultra High Voltage compatible.

3. A method as claimed in claim 2 wherein the coating is CrOx,, Al₂0₃ or any strongly absorbing metal oxide film.

4. A Physical Vapour Deposition apparatus including a vacuum chamber and a support disposed in the chamber for supporting a workpiece and a cooling circuit for cooling the support wherein the support includes an aluminium body having a support face and the support face is coated with a heat absorbing coating.

5. Apparatus as claimed in claim 4 wherein the coating is inert and/or Ultra High Voltage compatible.

6. Apparatus as claimed in claim 5 wherein the coating is CrOₓ or Al₂0₃.or any other strongly absorbing metal oxide film.

7. Apparatus as claimed in claims 4 to 6 wherein the support is cooled to around 100°C.
